# FASCICULE DE BREVET EUROPEEN

(11) **EP 0 642 671 B1**
(45) Date de publication et mention de la délivrance du brevet: **19.02.1997**
(21) Numéro de dépôt: 93912495.4
(22) Date de dépôt: 26.05.1993
(51) Int. Cl.: G01R 27/20

(54) **DISPOSITIF DE SONDE ET METHODE POUR MESURER LA RESISTIVITE D'UN SOL**
SONDENVORRICHTUNG UND VERFAHREN ZUR MESSUNG DES BODENWIDERSTANDES
PROBE AND METHOD OF MEASURING GROUND RESISTIVITY

(30) Priorité: 27.05.1992 US 888592
(43) Date de publication de la demande: 15.03.1995
(73) Titulaire: HYDRO-QUEBEC, Montréal Québec H2Z 1A4 (CA)
(72) Inventeur: CHAMPAGNE, Gilles, Y., Ste-Julie, Québec J3E 1J2 (CA); MONARQUE, Alexandre, Boucherville, Québec J4B 4N8 (CA)
(74) Mandataire: Polus, Camille
(86) Numéro de dépôt international: CA9300225
(87) Numéro de publication internationale: WO9324843

(56) Documents cités:
- FR-A- 823 163
- FR-A- 2 296 853
- US-A- 3 944 916

## Description

La présente vise un dispositif de sonde et une méthode pour mesurer la résistivité d'un sol. Le dispositif de sonde est adapté pour être relié à un appareil de mesure capable de générer un signal de courant continu constant entre deux fils électriques.

Étant donné que la résistivité électrique d'un sol varie entre autres, selon l'humidité et la température et étant donné que le sol est utilisé comme un matériau isolant par rapport à l'électricité, il est important de bien mesurer la résistivité du sol in situ.

Différentes techniques sont connues. Il y a la méthode de Schlumberger qui constitue un des principaux moyens pour mesurer la résistivité électrique d'un sol. Par cette méthode on détermine entre deux électrodes la chute de tension causée par un courant électrique injecté entre une seconde paire d'électrodes. La première paire d'électrodes est disposée entre la seconde paire d'électrodes. Un courant continu i est injecté entre la paire d'électrodes externes. Au moyen des deux électrodes internes, l'appareil mesure un voltage V. Avec la relation V=RI, la valeur de la résistance moyenne apparente R est établie. Au moyen de la valeur R la résistivité moyenne apparente ρ du sol est déterminée au moyen de la relation de Schlumberger: ρ=2πiR. De façon à minimiser les erreurs dues à la polarisation du sol ou à des courants de sol préexistants, la source de courant qui est utilisée est habituellement une source de courant alternative ou une source de courant continu commuté à une fréquence qui ne doit pas être 60 Hz ou une harmonique de 60 Hz.

Il est reconnu que la méthode de Schlumberger peut être relativement efficace pour mesurer la résistivité du sol à certaines profondeurs mais elle n'est pas efficace pour mesurer la résistivité d'une mince couche de sol, et ce particulièrement pour les couches situées en surface ou près de la surface. De plus, il est connu que la méthode de mesure de la résistivité du sol selon la méthode de Schlumberger ne peut pas être effectuée de façon continue parce qu'il se produit alors une polarisation qui fausse les résultats.

Dans Le brevet français n° 823,163, on décrit également une méthode pour mesurer la résistivité d'un sol comprenant des étapes où l'on dispose deux électrodes, ayant des surfaces conductrices disposées en vis-à-vis l'une de l'autre, dans le sol à des profondeurs prédéterminées et à une distance prédéterminée l'une de l'autre, et l'on injecte un signal de courant continu constant dans Lesdites électrodes lorsqu'une mesure de La résistivité doit être effectuée pour produire une tension entre Lesdites électrodes qui est représentative de la résistivité dudit sol entre lesdites électrodes, Le signal de courant continu étant injecté durant une période de temps suffisante pour permettre une stabilisation produite entre Lesdites électrodes. Cependant, cette méthode souffre des mêmes problèmes que ceux de La méthode de Schlumberger mentionnés ci-dessus.

Un des objectifs de la présente invention est de proposer un dispositif de sonde et une méthode par lesquels il est possible de mesurer la résistivité d'une mince couche de sol de façon continue ou ponctuelle.

La présente invention a également pour objectif de proposer un dispositif de sonde et une méthode par lesquels la résistivité du sol peut être mesurée sans produire de polarisation dudit sol.

### RESUME DE L'INVENTION

La présente invention vise un dispositif de sonde pour mesurer La résistivité de sol, destiné à être branché à un appareil de mesure capable de générer un signal de courant continu constant dans deux fils électriques , ledit dispositif comportant deux électrodes et un moyen de commutation pour relier les deux électrodes aux fils électriques de manière à injecter ledit signal de courant continu dans lesdites électrodes pour engendrer une tension entre lesdits fils électriques qui soit représentative de la résistivité du sol entre lesdites électrodes, chacune desdites électrodes ayant une partie de sa surface formant une surface conductrice, lesdites surfaces conductrices desdites électrodes étant disposées substantiellement en vis-à-vis l'une de l'autre lorsque lesdites électrodes sont disposées dans le sol, ledit dispositif étant caractérisé en ce qu'il comprend en outre :
une connexion de court-circuit ayant deux extrémités ;
et en ce que ledit moyen de commutation est un moyen de commutation bipolaire à deux directions ayant deux contacts fixes , et deux contacts mobiles pouvant être branchés alternativement soit aux fils électriques ou auxdites extrémités de ladite connexion de court-circuit respectivement ;
lesdites électrodes sont branchées auxdits contacts fixes respectivement ;
en position d'attente, lesdits contacts mobiles sont branchés à ladite connexion de court-circuit
en position d'opération pour effectuer une mesure, lesdits contacts mobiles sont branchés auxdits fils électriques dudit appareil de mesure,

Lesdits contacts mobiles étant ainsi commutés de ladite position d'attente à ladite position d'opération lorsqu'une mesure de la résistivité du sol doit être réalisée, le signal de courant continu ayant une amplitude déterminée de manière à prévenir une polarisation électrolytique du sol.

De plus, la présente invention vise une méthode pour mesurer la résistivité d'un sol comprenant des étapes où l'on dispose deux électrodes , ayant des surfaces conductrices disposées en vis-à-vis l'une de l'autre, dans ledit sol à des profondeurs prédéterminées et à une distance prédéterminée l'une de l'autre, et l'on injecte un signal de courant continu constant dans lesdites électrodes lorsqu'une mesure de la résistivité doit être effectuée pour produire une tension entre lesdites électrodes qui est représentative de la résistivité dudit sol entre lesdites électrodes , ledit signal de courant continu étant injecté durant une période de temps suffisante pour permettre une stabilisation de la tension produite entre lesdites électrodes , ladite méthode étant caractérisé en ce que :
on court-circuite lesdites électrodes au moyen d'une connexion de court-circuit lorsqu'aucune mesure de résistivité n'est effectuée ;
lorsqu'une mesure est effectuée, ledit signal de courant continu constant a une amplitude prédéterminée pour prévenir une polarisation électrolytique dudit sol, et ladite connexion de court-circuit est ouverte.

Les objectifs, avantages et autres caractéristiques de la présente invention seront mieux connus suite à la lecture de la description non-restrictive d'un mode de réalisation préférentiel qui est donné à titre seulement d'exemple en référence aux dessins ci-joints.

### BRÈVE DESCRIPTION DES DESSINS

La figure un (1) est une vue schématique qui illustre un dispositif de sonde en accord avec la présente invention.

La figure deux (2) est un diagramme schématique et est constituée en partie d'un diagramme bloc, qui montre un mode de réalisation de la présente invention en combinaison avec un appareil de mesure automatique.

### DESCRIPTION DÉTAILLÉE DES DESSINS

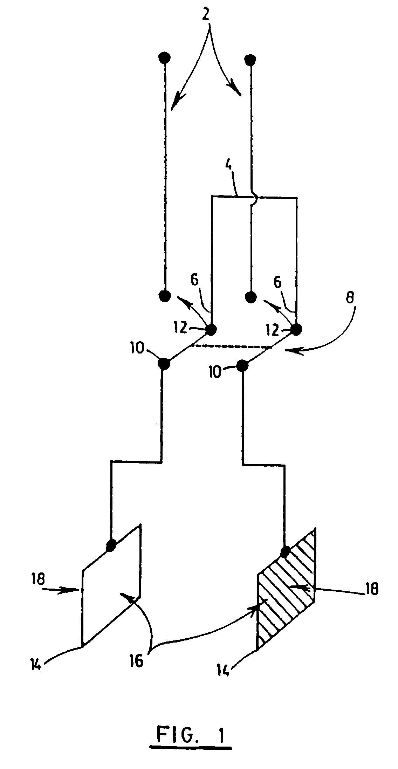

Si on se réfère à la figure un (1), on peut voir un dispositif de sonde servant à pour mesurer la résistivité d'un sol. Ce dispositif de sonde est prévu pour être branché à un appareil de mesure (non montré sur cette figure 1) capable de générer un signal de courant continu entre deux fils électriques.

Le dispositif de sonde comprend une connexion de court-circuit 4 ayant deux extrémités 6; et un moyen de commutation bipolaire à deux directions 8 ayant deux contacts fixes 10, et deux contacts mobiles 12 pouvant être branchés alternativement soit aux fils électriques 2 soit à la-connexion de court-circuit 4, respectivement.

Le dispositif de commutation comprend aussi deux électrodes 14 branchées aux contacts fixes 10 respectivement. Chacune des électrodes 14 a une partie 16 de sa surface qui forme une surface conductrice 16. Les surfaces conductrices 16 des électrodes 14 sont substantiellement disposées en vis-à-vis l'une de l'autre lorsque les électrodes sont installées dans le sol.

En position d'attente, les contacts mobiles 12 sont branchés à la connexion de court-circuit 4. En position d'opération pour effectuer une mesure, les contacts mobiles sont branchés aux fils électriques 2 de l'appareil de mesure (non montré). Ainsi lorsqu'une mesure de la résistivité du sol doit être effectuée, les contacts mobiles 12 sont branchés depuis la position en attente à la position d'opération de façon à ce que le signal de courant continu constant puisse être injecté dans les électrodes 14 pour ainsi produire une tension entre les fils électriques qui soit représentative de la résistivité du sol entre les électrodes 14.

Les électrodes 14 sont des plaques de forme carrée. Mais d'autres formes sont aussi possible.

Chacune des électrodes 14 a une partie restante 18 de sa surface qui ne doit pas faire partie de la surface conductrice 16 et qui doit être couverte d'un matériau isolant. Le matériau isolant peut être de la peinture en aérosol. Les électrodes 14 sont faites de cuivre.

En opération, la méthode pour mesurer la résistivité du sol comprend les étapes où on installe les deux électrodes 14 dans le sol à des profondeurs prédéterminées, à une distance prédéterminée l'une de l'autre et de façon à ce que leur surface conductrice 16 soit disposée en vis-à-vis l'une de l'autre; on court-circuite les électrodes 14 au moyen d'une connexion de court-circuit 4 lorsqu'aucune mesure n'est effectuée et on ouvre la connexion de court-circuit 4 et on injecte un signal de courant continu constant dans les électrodes 14 lorsqu'une mesure de résistivité doit être effectuée de façon à produire une tension entre les électrodes 14 qui soit représentative de la résistivité du sol entre les électrodes. Le signal de courant continu constant a une amplitude prédéterminée de façon à prévenir une polarisation électrolytique du sol. La connexion de court-circuit est ouverte durant une période de temps suffisante de façon à permettre une stabilisation de la tension produite entre les électrodes. De préférence, cette période de temps est d'au moins 60 secondes.

Par exemple, le signal de courant continu peut être de l'ordre de 10 µA à 100 µA et la distance prédéterminée peut être de l'ordre de 20 à 90 cm.

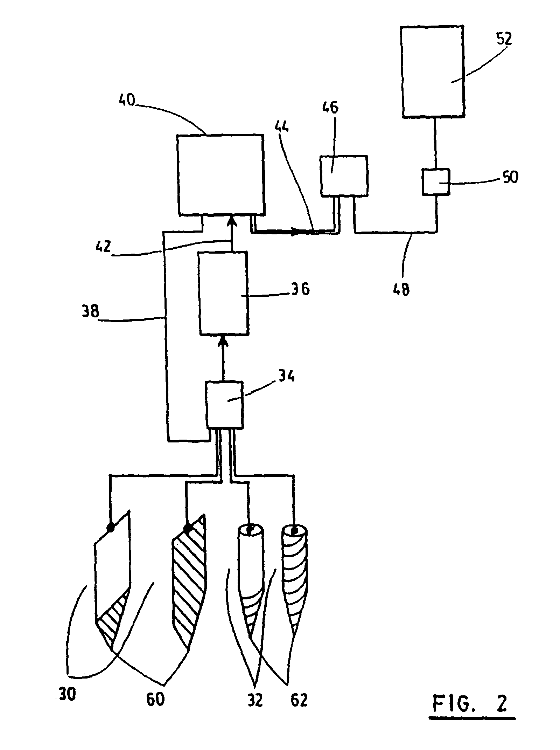

Si on se réfère maintenant à la figure 2, on montre le dispositif de sonde en question en combinaison avec un appareil de mesure servant à prendre automatiquement un échantillonnage de différentes mesures de la résistivité du sol. On montre deux paires d'électrodes 30 et 32, qui sont branchées à une carte Keithley (marque de commerce) qui est un dispositif de commutation 34 pouvant réaliser la même fonction qu'un commutateur bipolaire à deux directions 8 tel que montré à la figure 1, pour plusieurs paires d'électrodes 30 et 32. La carte Keithley 34 est contrôlée par un analyseur 36 Keithley de modèle 705 qui branchera en séquence chaque paire d'électrodes 30 et 32 à une ligne de signal 38 et qui activera simultanément l'électromètre programmable 40 Keithley de modèle 617 (marque de commerce) en envoyant un signal de déclenchement sur la ligne de déclenchement 42. Les différents signaux reçus des électrodes par l'électromètre 40 sont convertis en signaux numériques et envoyés sur un bus IEEE 44 à un convertisseur série RS232/IEEE 488A TECH (marque de commerce) pour convertir les signaux électriques venant du bus IEEE 44 en signaux qui puissent être envoyés sur le bus RS232 48. Ce bus RS232 48 est branché à l'entrée d'une interface 50 qui est un "shielded null modem" de modèle 336-3 INMAC (marque de commerce) qui est branchée à une mémoire électronique 52 de modèle 2050S tracker 2000 (marque de commerce) pour emmagasiner toute l'information qui est reçue.

Au moyen de l'électromètre 40, de l'analyseur 36 et du dispositif de commutation 34, il est possible d'ouvrir momentanément la connexion de court-circuit entre chaque paire d'électrodes 30 ou 32 d'une manière successive pour réaliser un échantillonnage de différentes mesures de résistivité dans le temps.

L'électromètre programmable 40 comprend une source de courant continu pour générer le signal de courant continu qui est de l'ordre de 10 µA à 100 µA et un voltamètre de courant continu pour mesurer la tension entre les fils électriques branchés à chaque paire d'électrodes 30 et 32.

Chacune des électrodes 30 est substantiellement rectangulaire et caractérisée par le fait qu'un de ses côtés étroits est terminé par une extrémité pointue 60 de façon à ce que les électrodes 30 puissent être facilement installées dans le sol. Les extrémités pointues 60 sont couvertes d'un matériau isolant qui peut être de la peinture en aérosol.

Chacune des électrodes 32 est une tige cylindrique avec une extrémité pointue 62 de façon à ce que les électrodes 32 puissent être facilement installées dans le sol. Dans la figure 2, la partie des électrodes 30 et 32, qui n'est pas couverte de lignes transversales, représente des surfaces qui ne sont pas couvertes d'un matériau isolant.

### RÉSULTATS EXPÉRIMENTAUX

Le sol où différentes mesures doivent être effectuées a été divisé en trois zones, soit deux zones principales et une zone de plus petite dimension. Cette division de l'endroit où on effectue des tests prend en considération le drainage et l'inclinaison du sol. Une des zones principales n'est pas drainée tandis que l'autre zone principale couvre un drain et est par conséquent drainée. Les deux zones sont séparées par une zone secondaire. Pour déterminer l'influence du drainage, une distribution semblable d'électrodes a été effectuée dans le sol dans chacune des zones principales. Ainsi, trois systèmes d'électrodes ont été disposés dans la zone drainée et trois autres systèmes d'électrodes équivalents ont été disposés dans la zone non drainée.

Les premier et second systèmes d'électrodes consistant en deux paires d'électrodes montées dans chacune des zones principales. La première paire d'électrodes est faite de plaques de cuivre ayant des dimensions 0.30 mètre par 0.30 mètre, et la seconde paire d'électrodes est également faite de plaques de cuivre ayant des dimensions de 0.10 mètre par 0.10 mètre. Chaque plaque de cuivre a une de ses faces couvertes d'une peinture isolante. Les plaques sont disposées dans le sol durant la préparation du sol en question ou après sa préparation. Les électrodes sont montées l'une en face de l'autre et leurs surfaces peintes sont tournées vers l'extérieur. L'espace entre les plaques est entre 0.20 et 0.70 mètres. Le troisième système d'électrodes est disposé dans chacune des zones principales. Ce troisième système est un réseau d'électrodes fait de quatre tiges d'acier couvertes de cuivre. Chaque tige a une longueur de 0.30 mètre et un diamètre de 0.016 mètre. Ces électrodes sont équidistantes et alignées, la distance entre les électrodes étant de 0.88 mètre. Au moyen de ce troisième système d'électrodes, une mesure selon les méthodes Schlumberger peut être réalisée.

Au moyen des deux premiers systèmes d'électrodes, la méthode de mesure selon la présente invention peut être réalisée. Cette méthode requiert l'injection d'un courant électrique dans le sol. La résistivité du sol est déterminée principalement en injectant un courant continu constant dans le sol au moyen des électrodes, et en mesurant le voltage entre lesdites électrodes. Au moyen du troisième système d'électrodes, la méthode de Schlumberger à quatre points a été effectuée. Cette méthode a été utilisée pour fin de comparaison avec les résultats obtenus dans la présente invention.

Durant le test, l'électromètre utilisé était un électromètre de modèle 617 fait par Keithley (marque de commerce). Le volume de sol existant entre les électrodes est équivalent à une résistance électrique. L'électromètre mesure la valeur de la résistance R apparente moyenne du sol. La valeur R, une fois qu'elle a été mesurée, permet de calculer la valeur de la résistivité apparente du sol existant entre les électrodes. Ce calcul est fait au moyen de l'équation suivante ρ=R(A/L) où A est la surface de la section transversale du volume de sol présent entre les électrodes, L est la distance entre les électrodes et R est la résistance apparente moyenne du sol mesurée par l'électromètre.

L'équation mentionnée ci-dessus établit un lien entre la résistance mesurée, la distance entre les électrodes et la surface de la section transversale. Aussi, selon l'équation mentionnée ci-dessus, le volume de sol existant entre les électrodes est considéré comme un médium où la résistivité électrique est homogène.

Un facteur de correction k est introduit, dans l'équation mentionnée ci-dessus qui devient ρ=Rk(A/L), pour annuler l'influence du système de mesure. Un médium électrique homogène pour lequel ρ est connu, est utilisé pour déterminer le facteur de correction k. Pour établir ce facteur k, chaque paire d'électrodes a été submergée dans une solution KCl de 0.01 molaire à des distances prédéterminées.

L'opération du système de mesures Schlumberger est bien connue. Un courant continu i est injecté entre la paire d'électrodes externes. Au moyen des deux électrodes internes, l'appareil mesure un voltage V. Avec la relation V=RI, la valeur de la résistance moyenne apparente R est établie. Au moyen de la valeur R la résistivité moyenne apparente ρ du sol est déterminée au moyen de la relation de Schlumberger: ρ=2πiR.

Lorsque les électrodes de cuivre sont installées dans le sol, il se produit une polarisation instantanée des électrodes. Cette différence de potentiel entre les électrodes peut être mesurée.

Une différence de potentiel d'environ 0.20 volt a été mesurée entre des plaques 0.09 m². Cette valeur est suffisante pour produire un important changement dans les valeurs de résistance mesurées par l'électromètre qui fonctionne avec un courant continu constant. Il a été trouvé que cette polarisation spontanée peut être prévenue en branchant les électrodes ensemble lorsqu'aucune mesure n'est effectuée. La méthode selon la présente invention a été développée et adaptée pour mesurer la résistivité d'un sol tout en prévenant au moyen d'une connexion de court-circuit, la présence d'un phénomène parasite connu sous le nom de polarisation spontanée, qui introduit des erreurs dans les valeurs qui sont mesurées.

Avec la présente invention, il est possible de déterminer l'influence de certaines conditions climatiques telles que la température ambiante et la pluie sur la résistivité du sol ce qui n'est pas le cas pour la méthode de Schlumberger avec laquelle il est très difficile sinon impossible d'obtenir une valeur représentative de la résistivité du sol par rapport aux variations de conditions climatiques.

## Revendications

1. Dispositif de sonde pour mesurer la résistivité de sol, destiné à être branché à un appareil de mesure capable de générer un signal de courant continu constant dans deux fils électriques (2), ledit dispositif comportant deux électrodes (14) et un moyen de commutation pour relier les deux électrodes aux fils électriques de manière à injecter ledit signal de courant continu dans lesdites électrodes (14) pour engendrer une tension entre lesdits fils électriques (2) qui soit représentative de la résistivité du sol entre lesdites électrodes, chacune desdites électrodes (14) ayant une partie de sa surface formant une surface conductrice (16), lesdites surfaces conductrices (16) desdites électrodes (14) étant disposées substantiellement en vis-à-vis l'une de l'autre lorsque lesdites électrodes (14) sont disposées dans le sol, ledit dispositif étant caractérisé en ce qu'il comprend en outre :
une connexion de court-circuit (4) ayant deux extrémités (6) ;
et en ce que ledit moyen de commutation est un moyen de commutation bipolaire à deux directions (8;34) ayant deux contacts fixes (10), et deux contacts mobiles (12) pouvant être branchés alternativement soit aux fils électriques (2) ou auxdites extrémités de ladite connexion de court-circuit (4) respectivement ;
lesdites électrodes (14) sont branchées auxdits contacts fixes (10) respectivement ;
en position d'attente, lesdits contacts mobiles (12) sont branchés à ladite connexion de court-circuit (4);
en position d'opération pour effectuer une mesure, lesdits contacts mobiles (12) sont branchés auxdits fils électriques (2) dudit appareil de mesure,
Lesdits contacts mobiles (12) étant ainsi commutés de ladite position d'attente à ladite position d'opération lorsqu'une mesure de la résistivité du sol doit être réalisée, le signal de courant continu ayant une amplitude déterminée de manière à prévenir une polarisation électrolytique du sol.

2. Dispositif de sonde selon la revendication 1, dans lequel chacune desdites électrodes (30) est substantiellement rectangulaire et où un de ses côtés étroits se termine par une extrémité pointue (60) de façon à ce que lesdites électrodes (30) puissent être facilement insérées dans ledit sol, ladite extrémité pointue (60) étant couverte d'un matériau isolant.

3. Dispositif de sonde selon la revendication 1, dans lequel lesdites électrodes (14) sont des plaques de forme carrée.

4. Dispositif de sonde selon la revendication 1, dans lequel lesdites électrodes (32) sont des tiges cylindriques ayant chacune une extrémité pointue de façon à ce que lesdites électrodes (32) puissent être facilement insérées dans ledit sol.

5. Dispositif de sonde selon la revendication 2,3 ou 4 dans lequel chacune desdites électrodes (14,30,32) a une partie de sa surface restante qui ne constitue pas ladite surface conductrice et qui est ouverte d'un matériau isolant.

6. Dispositif de sonde selon la revendication 5, dans lequel lesdites électrodes (14,30,32) sont faites de cuivre.

7. Dispositif de sonde selon la revendication 6, dans lequel ledit matériau isolant est de la peinture en aérosol.

8. Dispositif de sonde selon la revendication 1, en combinaison avec ledit appareil de mesure, où ledit appareil de mesure comprend :
une source de courant continu constant (40) pour générer ledit signal de courant continu qui est de l'ordre de 10 µA à 100 µA ;
un voltmètre en courant continu (40) pour mesurer ledit voltage entre lesdits fils électriques.

9. Dispositif de sonde en combinaison avec un appareil de mesure selon la revendication 8, comprenant en outre un générateur de signal déclencheur (36) ayant une sortie de commande branchée audit moyen de commutation bipolaire à deux directions (34) pour momentanément commuter lesdits contacts mobiles de ladite position d'attente à ladite position d'opération, ainsi une mesure de la résistivité dudit sol peut être échantillonnée dans le temps au moyen dudit générateur de signal déclencheur (36).

10. Méthode pour mesurer la résistivité d'un sol comprenant des étapes où l'on dispose deux électrodes (14), ayant des surfaces conductrices disposées en vis-à-vis l'une de l'autre, dans ledit sol à des profondeurs prédéterminées et à une distance prédéterminée l'une de l'autre, et l'on injecte un signal de courant continu constant dans lesdites électrodes (14) lorsqu'une mesure de la résistivité doit être effectuée pour produire une tension entre lesdites électrodes (14) qui est représentative de la résistivité dudit sol entre lesdites électrodes (14), ledit signal de courant continu étant injecté durant une période de temps suffisante pour permettre une stabilisation de la tension produite entre lesdites électrodes (14), ladite méthode étant caractérisé en ce que :
on court-circuite lesdites électrodes (14) au moyen d'une connexion de court-circuit (4) lorsqu'aucune mesure de résistivité n'est effectuée ;
lorsqu'une mesure est effectuée, ledit signal de courant continu constant a une amplitude prédéterminée pour prévenir une polarisation électrolytique dudit sol, et ladite connexion de court-circuit (4) est ouverte.

11. Méthode selon la revendication 10, dans laquelle ledit signal de courant continu est substantiellement de l'ordre de 10 µA à 100 µA.

12. Méthode selon la revendication 10, dans laquelle ladite distance prédéterminée est substantiellement de l'ordre de 20 à 70 cm.

13. Méthode selon la revendication 10, dans laquelle ladite étape où on ouvre ladite connexion de court-circuit (4) comprend une étape où on ouvre de façon momentanée et à plusieurs reprises ladite connexion de court-circuit (4) pour réaliser un échantillonnage de mesures de résistivité dans le temps.

14. Méthode selon la revendication 11, dans laquelle ladite période de temps suffisante est d'au moins 60 secondes.

## Patentansprüche

1. Sondenvorrichtung zum Messen des spezifischen Bodenwiderstandes zur Verbindung mit einem Meßgerät, das ein konstantes Gleichstromsignal in zwei elektrischen Leitern (2) erzeugen kann, welche Vorrichtung zwei Elektroden (14) und eine Schalteinrichtung zum Verbinden der beiden Elektroden mit den elektrischen Leitern aufweist derart, daß das Gleichstromsignal den genannten Elektroden (14) eingegeben wird, um eine Spannung zwischen den genannten elektrischen Leitern (2) zu erzeugen, die für den spezifischen Bodenwiderstand zwischen den genannten Elektroden repräsentativ ist, wobei jede der genannten Elektroden (14) einen Teil ihrer Oberfläche aufweist, der eine leitende Fläche (16) bildet, die genannten leitenden Flächen (16) der genannten Elektroden (14) im wesentlichen einander gegenüber angeordnet sind, wenn die genannten Elektroden (14) im Boden angeordnet sind, welche Vorrichtung dadurch gekennzeichnet ist, daß sie weiterhin:
eine Kurzschlußverbindung (4) mit zwei Enden (6) umfaßt und
die genannte Schalteinrichtung eine bipolare Zweirichtungsschalteinrichtung (8; 34) mit zwei festen Kontakten (10) und zwei beweglichen Kontakten (12) ist, die abwechselnd mit den beiden elektrischen Leitern (2) oder den genannten Enden der genannten Kurzschlußverbindung (4) jeweils verbunden werden können,
die genannten Elektroden (14) jeweils mit den festen Kontakten (10) verbunden sind,
in der Warteposition die beweglichen Kontakte (12) mit der genannten Kurzschlußverbindung (4) verbunden sind,
in der Betriebsposition zum Bewirken einer Messung die beweglichen Kontakte (12) mit den elektrischen Leitern (2) des genannten Meßgerätes verbunden sind,
die beweglichen Kontakte (12) daher von der Warteposition auf die Betriebsposition umgeschaltet werden, wenn eine Messung des spezifischen Bodenwiderstandes erfolgen soll, wobei das Gleichstromsignal eine derartige bestimmte Amplitude hat, daß eine elektrolytische Polarisierung des Bodens verhindert ist.

2. Sondenvorrichtung nach Anspruch 1, bei der jede der genannten Elektroden (30) im wesentlichen rechtwinklig ist und an einer ihrer schmalen Seiten in einem zugespitzten Ende (60) mündet, derart, daß die genannten Elektroden (30) leicht in den Boden eingesetzt werden können, wobei das genannte zugespitzte Ende (60) von einem Isoliermaterial überzogen ist.

3. Sondenvorrichtung nach Anspruch 1, bei der die Elektroden (14) viereckig geformte Platten sind.

4. Sondenvorrichtung nach Anspruch 1, bei der die genannten Elektroden (32) zylindrische Schäfte sind, die jeweils ein zugespitztes Ende aufweisen, derart, daß die besagten Elektroden (32) leicht in den Boden eingesetzt werden können.

5. Sondenvorrichtung nach Anspruch 2, 3 oder 4, bei der jede der genannten Elektroden (14, 30, 32) einen verbleibenden Teil ihrer Oberfläche aufweist, der nicht zu der besagten leitenden Oberfläche beiträgt und mit einem isolierenden Material überzogen ist.

6. Sondenvorrichtung nach Anspruch 5, bei der die besagten Elektroden (14, 30, 32) aus Kupfer bestehen.

7. Sondenvorrichtung nach Anspruch 6, bei der das Isoliermaterial aus einem Aerosolanstrich besteht.

8. Sondenvorrichtung nach Anspruch 1 in Kombination mit dem besagten Meßgerät, wobei das besagte Meßgerät
eine Konstantgleichstromquelle (40) zum Erzeugen des besagten Gleichstromsignals, das in der Größenordnung von 10 µA bis 100 µA liegt, und
einen Gleichspannungsvoltmesser (40) zum Messen der Spannung zwischen den elektrischen Leitern umfaßt.

9. Sondenvorrichtung in Kombination mit einem Meßgerät nach Anspruch 8, welches weiterhin einen Auslösesignalgenerator (36) mit einem Steuerausgang umfaßt, der mit der bipolaren Zweirichtungsschalteinrichtung (34) verbunden ist, um kurzzeitig die beweglichen Kontakte von der Warteposition auf die Betriebsposition umzuschalten, so daß eine Probemessung des spezifischen Bodenwiderstandes in Zeittakten mittels des Auslösesignalgenerators (36) möglich ist.

10. Verfahren zum Messen des spezifischen Bodenwiderstandes, welches Schritte umfaßt, bei denen man zwei Elektroden (14) mit leitenden Flächen, die einander gegenüber angeordnet sind, im Boden auf bestimmten Tiefen und mit einem bestimmten Abstand voneinander anordnet, ein konstantes Gleichstromsignal den genannten Elektroden (14) eingibt, wenn eine Messung des spezifischen Widerstandes bewirkt werden soll, um eine Spannung zwischen den besagten Elektroden (14) zu erzeugen, die den spezifischen Bodenwiderstand zwischen den besagten Elektroden (14) wiedergibt, wobei das Gleichstromsignal während einer Zeitdauer eingegeben wird, die ausreicht, um eine Stabilisierung der Spannung zu ermöglichen, die zwischen den besagten Elektroden (14) erzeugt wird, welches Verfahren dadurch gekennzeichnet ist, daß
man die besagten Elektroden (14) mittels einer Kurzschlußverbindung (4) kurzschließt, wenn eine Messung des spezifischen Widerstandes nicht erfolgen soll,
dann, wenn eine Messung bewirkt werden soll, das besagte konstante Gleichstromsignal eine bestimmte Amplitude hat, bei der eine elektrolytische Polarisierung des Bodens verhindert ist, und die genannte Kurzschlußverbindung (4) geöffnet wird.

11. Verfahren nach Anspruch 10, bei dem das Gleichstromsignal im wesentlichen der Größenordnung von 10 µA bis 100 µA liegt.

12. Verfahren nach Anspruch 10, bei dem der bestimmte Abstand im wesentlichen in der Größenordnung von 20 bis 70 cm liegt.

13. Verfahren nach Anspruch 10, bei dem der genannte Schritt, in dem die Kurzschlußverbindung (4) geöffnet wird, einen Schritt umfaßt, in dem kurzzeitig und wiederholt die besagte Kurzschlußverbindung (4) geöffnet wird, um Probemessungen des spezifischen Widerstandes in Zeittakten durchzuführen.

14. Verfahren nach Anspruch 11, bei dem die besagte ausreichende Zeitdauer wenigstens 60 Sekunden beträgt.

## Claims

1. Probe assembly for measuring resistivity of a soil, to be connected to a measuring apparatus capable of generating a constant DC current signal into two electric leads (2), the assembly comprising two electrodes (14) and a switching means for connecting the two electrodes to the electric leads so as to inject said constant DC current signal into said electrodes (14) and produce a voltage between said electrical leads (2) which is indicative of the resistivity of said soil between said electrodes, each of said electrodes (14) having a portion of its surface forming a conductive surface (16), said conductive surfaces (16) of said electrodes (14) being substantially opposite to each other when said electrodes are put into said soil, the assembly being characterized in that it further comprises:
a short circuit connector (4) having two ends (6);
and in that said switching means is a double-pole double-throw switching means (8;34) having two fixed contacts (10), and two switched contacts (12) alternatively connectable to said electric leads (2) or to said ends of said short circuit connector (4), respectively;
said electrodes (14) are connected to said fixed contacts (10) respectively;
in a stand-by position, said switched contacts (12) are connected to said short circuit connector (4);
in an operating position for measurement, said switched contacts (12) are connected to said electrical leads (2) of said measuring apparatus, said switched contacts (12) being this way switched from said stand-by position to said operating position when a measurement of the resistivity of the soil has to be performed, the constant DC current signal having an amplitude determined so as to prevent an electrolytic polarization of the soil.

2. A probe assembly according to claim 1, wherein each of said electrodes (30) is substantially rectangular with one of its narrow sides terminated by a pointed end (60) so that said electrodes (30) can be easily put into said soil, said pointed end (60) being covered with an insulating material.

3. A probe assembly according to claim 1, wherein said electrodes (14) are square-shaped plates.

4. A probe assembly according to claim 1, wherein said electrodes (32) are cylindrical rods each having a pointed end so that said electrodes (32) can be easily put into said soil.

5. A probe assembly according to claim 2, 3 or 4, wherein each of said electrodes (14, 30, 32) has a remaining portion of its surface that does not form said conductive surface, and that is covered with an insulating material.

6. A probe assembly according to claim 5, wherein said electrodes (14, 30, 32) are made of copper.

7. A probe assembly according to claim 6, wherein said insulating material is spray paint.

8. A probe assembly according to claim 1, in combination with said measuring apparatus, wherein said measuring apparatus comprises:
a constant DC current source (40) for generating said DC current signal which is in the order of 10 µA to 100 µA; and
a DC voltmeter (40) for detecting said voltage between said electric leads.

9. A probe assembly in combination with a measuring apparatus according to claim 8, further comprising a trigger signal generator (36) having a command output connected to said double-pole double-throw switching means (34) for momentarily switching said switched contacts from said stand-by position to said operating position, whereby a measurement of the resistivity of said soil can be sampled with respect to time by means of said trigger signal generator (36).

10. A method for measuring resistivity of a soil, comprising the steps of putting two electrodes (14) in said soil at predetermined depths, at a predetermined distance from each other, the electrodes 14 having conductive surfaces facing each other; and injecting a constant DC current signal into said electrodes (14) when a measurement of resistivity is performed to produce a voltage between said electrodes (14) that is indicative of the resistivity of said soil between said electrodes (14), said constant DC current signal being injected during a period of time sufficient to allow a stabilization of said voltage produced between said electrodes (14), said method being characterized by the steps of:
short circuiting said electrodes (14) by means of a short circuit connector (4) when no measurement of resistivity is performed; and
when a measurement of resistivity is performed, said constant DC current signal has a predetermined amplitude to prevent an electrolytic polarization of said soil, and said short circuit connector (4) is open.

11. A method according to claim 10, wherein said DC current signal is substantially in the order of 10 µA to 100 µA.

12. A method according to claim 10, wherein said predetermined distance is substantially in the order of 20 to 70 centimetres.

13. A method according to claim 10, wherein said step where said short circuit connector (4) is open comprises a step where said short circuit connector (4) is open momentarily and in a successive manner to perform a sampling of resistivity measurements with respect to time.

14. A method according to claim 11, wherein said time period is at least 60 seconds.
